(19) Europäisches Patentamt
European Patent Office
Office européen des brevets

(11) Veröffentlichungsnummer: **0 051 185**
**B1**

# (12) EUROPÄISCHE PATENTSCHRIFT

(45) Veröffentlichungstag der Patentschrift: **10.04.85**

(51) Int. Cl.[4]: **G 03 F 7/08**

(21) Anmeldenummer: **81108388.0**

(22) Anmeldetag: **16.10.81**

## (54) Lichtempfindliches Gemisch und damit hergestelltes lichtempfindliches Kopiermaterial.

(30) Priorität: **24.10.80 DE 3040156**

(43) Veröffentlichungstag der Anmeldung: **12.05.82 Patentblatt 82/19**

(45) Bekanntmachung des Hinweises auf die Patenterteilung: **10.04.85 Patentblatt 85/15**

(84) Benannte Vertragsstaaten: **AT BE CH DE FR GB LI NL**

(56) Entgegenhaltungen:
**DE - A - 1 447 919**
**US - A - 4 174 222**

(73) Patentinhaber: **HOECHST AKTIENGESELLSCHAFT, Postfach 80 03 20, D-6230 Frankfurt am Main 80 (DE)**

(72) Erfinder: **Stahlhofen, Paul, Dr., Leibnizstrasse 18/B, D-6200 Wiesbaden (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

EP 0 051 185 B1

**Beschreibung**

Die Erfindung betrifft ein positiv arbeitendes lichtempfindliches Gemisch, das ein wasserunlösliches, in wässrig-alkalischen Lösungen lösliches oder quellbares harzartiges Bindemittel und als lichtempfindliche Verbindung einen Naphthochinondiazid-sulfonsäureester eines substituierten Pyrogallols enthält.

Aus der JP-OS 51/139 402 ist es bekannt, Ester aus 3 Mol Naphthochinon-(1,2)-diazid-(2)-sulfonsäuren und 1 Mol Gallussäurealkylestern mit 2 bis 5 Kohlenstoffatomen in der Alkylgruppe in Kombination mit Novolaken für die Herstellung positiv arbeitender lichtempfindlicher Materialien, insbesondere von Photoresistschichten zu verwenden. Die dort beschriebenen Chinondiazide sollen sich durch hohe Lichtempfindlichkeit und gute Löslichkeit in organischen Lösungsmitteln auszeichnen. Obwohl die Löslichkeit im Vergleich zu anderen bisher für die Herstellung von Offsetdruckplatten verwendeten Chinondiaziden verbessert ist, reicht sie für viele Zwecke noch nicht aus, und es besteht immer eine Neigung, dass solche Verbindungen aus den in grossem Massstab hergestellten und verwendeten Beschichtungslösungen bei längerem Stehen auskristallisieren. Dadurch wird die Gleichmässigkeit der erhaltenen Kopierschichten empfindlich gestört. Dieser Nachteil macht sich besonders bei Beschichtungsverfahren bemerkbar, bei denen man relativ hochkonzentrierte Beschichtungslösungen verwenden muss, z.B. bei der Beschichtung mittels Gravur-coater.

Aufgabe der Erfindung war es, ein lichtempfindliches Gemisch der eingangs angegebenen Gattung auf Basis neuer Naphthochinon-(1,2)-diazid-(2)-sulfonsäureester mit höherer Löslichkeit in organischen Lösungsmitteln vorzuschlagen, das in allen druck- und kopiertechnischen Eigenschaften den besten bekannten Gemischen mindestens vergleichbar sein sollte. Die Verbindungen sollten ferner eine höhere Oleophilie als die bekannten Verbindungen aufweisen und leicht herstellbar sein.

Die Erfindung geht aus von einem lichtempfindlichen Gemisch, das einen Naphthochinon-(1,2)-diazid-(2)-4- oder -5-sulfonsäureester eines Gallussäurealkylesters oder eines Pyrogallylalkylketons und ein wasserunlösliches, in wässrig-alkalischen Lösungen lösliches oder mindestens quellbares harzartiges Bindemittel enthält.

Das erfindungsgemässe lichtempfindliche Gemisch ist dadurch gekennzeichnet, dass es einen Naphthochinondiazid-sulfonsäureester der allgemeinen Formel I

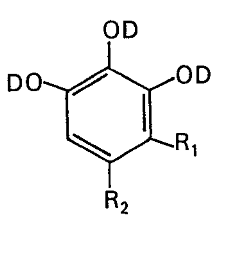

I

enthält, worin

D einen Naphthochinon-(1,2)-diazid-(2)-4-sulfonyl- oder bevorzugt einen Naphthochinon-(1,2)-diazid-(2)-5-sulfonylrest,
$R_1$ ein Wasserstoffatom oder den Rest $-COC_nH_{2n+1}$ und
$R_2$ ein Wasserstoffatom oder den Rest $-COOC_nH_{2n+1}$ bedeutet,

wobei

n eine Zahl von 10 bis 25 und die Summe der Kohlenstoffatome von $R_1 + R_2 = n + 1$ ist.

Die in dem erfindungsgemässen Gemisch verwendeten o-Chinondiazide sind neu. Ihre Herstellung erfolgt in Analogie zu bekannten Verfahren durch Veresterung der phenolischen Gruppen mit den entsprechenden o-Chinondiazid-sulfonsäuren oder deren reaktionsfähigen Derivaten, z.B. den Sulfonsäurechloriden.

Die langkettigen 4-Acyl-pyrogallole erhält man vorteilhaft durch Umsetzung von Pyrogallol mit den entsprechenden langkettigen Carbonsäuren bei 130–150°C in Gegenwart von wasserfreiem Zinkchlorid (Nencki-Reaktion). Die Herstellung der langkettigen Alkylester erfolgt mit guter Ausbeute durch Veresterung der 3,4,5-Trihydroxybenzoesäure mit den höheren aliphatischen Alkoholen. Der Gallussäure-n-dodecylester lässt sich beispielsweise nach van der Kerk, Verbeck und Cleton (beschrieben in Recueil des travaux chimiques des Pays-Bas 70 [1951], 277) leicht herstellen durch mehrstündiges Kochen eines Gemisches von 1 Mol Gallussäure und 5 Mol n-Dodecylalkohol in Xylol in Gegenwart von p-Toluolsulfonsäure. Das sich bildende Reaktionswasser wird mit Hilfe eines Wasserabscheiders azeotrop aus dem Gleichgewicht entfernt. (Siehe auch «Houben-Weyl»: Methoden der organischen Chemie, 4. Auflage, Band VIII, Seite 524). Die Veresterung mit noch höheren Alkoholen, z.B. n-Octadecylalkohol, wird vorteilhafter durch mehrstündiges Kochen in Anisol in Gegenwart von Nitrobenzol durchgeführt. Der Anteil an Nitrobenzol sollte der zu veresternden Säure äquivalent sein. Auch in diesem Falle ist p-Toluolsulfonsäure ein wirksamer Katalysator. Im allgemeinen werden die Alkylester gegenüber den Alkylketonen bevorzugt, da sie leichter herstellbar sind.

Die Konzentration der neuen Naphthochinondiazidsulfonsäureester in der lichtempfindlichen Schicht kann in relativ weiten Grenzen schwanken. Im allgemeinen liegt der Anteil bei 3 bis 50%, vorzugsweise zwischen 7 und 25%, bezogen auf das Gewicht des Feststoffanteils des lichtempfindlichen Gemischs.

Die erfindungsgemässen lichtempfindlichen Gemische enthalten ferner ein polymeres, wasserunlösliches harzartiges Bindemittel, das sich in den für das erfindungsgemässe Gemisch verwendeten Lösungsmitteln löst und in wässrigen Alkalien ebenfalls löslich oder zumindest quellbar ist.

Die bei vielen Positiv-Kopiermaterialien auf Basis von Naphthochinondiaziden bewährten Novolak-Kondensationsharze haben sich als Zusatz auch bei den erfindungsgemässen Gemischen mit den neuen Naphthochinondiazidsulfonsäureestern als besonders brauchbar und vorteilhaft erwiesen. Sie fördern die starke Differenzierung zwischen den belichteten und unbelichteten Schichtpartien beim Entwickeln, besonders die höher kondensierten Harze mit substituierten Phenolen, z.B. Kresolen, als Formaldehyd-Kondensationspartner. Als weitere alkalilösliche bzw. in Alkali quellbare Bindemittel sind natürliche Harze, wie Schellack und Kolophonium, und synthetische Harze, wie Mischpolymerisate aus Styrol und Maleinsäureanhydrid oder Mischpolymerisate der Acrylsäure oder Methacrylsäure, insbesondere mit Acryl- oder Methacrylsäureestern, zu nennen.

Die Art und Menge des alkalilöslichen Harzes kann je nach Anwendungszweck verschieden sein; bevorzugt sind Anteile am Gesamtfeststoff zwischen 95 und 50, besonders bevorzugt 90–65 Gew.%. Zusätzlich können noch zahlreiche andere Harze mitverwendet werden, bevorzugt Epoxide und Vinylpolymerisate wie Polyvinylacetate, Polyacrylate, Polyvinylacetale, Polyvinylether, Polyvinylpyrrolidone und die Mischpolymerisate der ihnen zugrundeliegenden Monomeren. Der günstigste Anteil an diesen Harzen richtet sich nach den anwendungstechnischen Erfordernissen und dem Einfluss auf die Entwicklungsbedingungen und beträgt im allgemeinen nicht mehr als 20 Gew.% vom alkalilöslichen Harz. In geringen Mengen kann das lichtempfindliche Gemisch für spezielle Erfordernisse wie Flexibilität, Haftung, Glanz, Färbung und Farbumschlag etc. ausserdem noch Substanzen wie Polyglykole, Cellulose-Derivate wie Ethylcellulose, Netzmittel, Farbstoffe, Haftvermittler und feinteilige Pigmente sowie bei Bedarf UV-Absorber enthalten.

Zur Beschichtung eines geeigneten Schichtträgers werden die Gemische im allgemeinen in einem Lösungsmittel gelöst. Die Wahl der Lösungsmittel ist auf das vorgesehene Beschichtungsverfahren, die Schichtdicke und die Trocknungsbedingungen abzustimmen. Geeignete Lösungsmittel für das erfindungsgemässe Gemisch sind Ketone wie Methylethylketon, chlorierte Kohlenwasserstoffe wie Trichlorethylen und 1,1,1-Trichlorethan, Alkohole wie n-Propanol, Ether wie Tetrahydrofuran, Alkoholether wie Ethylenglykolmonoethylether und Ester wie Butylacetat. Es können auch Gemische verwendet werden, die zudem noch für spezielle Zwecke Lösungsmittel wie Acetonitril, Dioxan oder Dimethylformamid enthalten können. Partialether von Glykolen, insbesondere Ethylenglykolmonomethylether, werden besonders bevorzugt.

Als Schichtträger für Schichtdicken unter ca. 10 µm werden meist Metalle verwendet. Für Offsetdruckplatten können eingesetzt werden: walzblankes, mechanisch oder elektrochemisch aufgerauhtes und ggf. anodisiertes Aluminium, das zudem noch chemisch, z.B. mit Polyvinylphosphonsäure, Silikaten oder Phosphaten, vorbehandelt sein kann, ausserdem Mehrmetallplatten z.B. aus Al/Cu/Cr oder aus Messing/Chrom. Für die Herstellung von Hochdruckplatten können die erfindungsgemässen Gemische auf Zink- oder Magnesium-Platten sowie deren handelsübliche mikrokristalline Legierungen für Einstufenätzverfahren aufgetragen werden, ausserdem auf ätzbare Kunststoffe wie Polyoxymethylen. Für Tiefdruck- oder Siebdruckformen eignen sich die erfindungsgemässen Gemische durch ihre gute Haftung und Ätzfestigkeit auf Kupfer- und Nickeloberflächen. Ebenso lassen sich die erfindungsgemässen Gemische als Photoresists in der Leiterplattenfertigung und beim Formteilätzen verwenden.

Für weitere Anwendungen kommen auch andere Träger wie Holz, Papier, Keramik, Textil und andere Metalle in Betracht.

Bevorzugte Träger für dicke Schichten über 10 µm sind Kunststoff-Folien, die dann als temporäre Träger für Transferschichten dienen. Dafür und für Farbprüffolien werden Polyesterfolien, z.B. aus Polyethylenterephthalat, bevorzugt. Polyolefinfolien wie Polypropylen sind jedoch ebenfalls geeignet.

Die Beschichtung des Trägermaterials erfolgt in bekannter Weise durch Aufschleudern, Sprühen, Tauchen, Walzen, mittels Breitschlitzdüsen, Rakeln oder durch Giesser-Antrag. Schliesslich kann die Beschichtung von z.B. Leiterplatten, Glas oder Keramik und Silizium-Scheiben auch durch Schichtübertragung von einem temporären Träger erfolgen. Belichtet wird mit den in der Technik üblichen Lichtquellen. Auch das Bestrahlen mit Elektronen oder Lasern stellt eine Möglichkeit zur Bebilderung dar.

Die zum Entwickeln verwendeten wässrig-alkalischen Lösungen abgestufter Alkalität, die auch kleinere Mengen organischer Lösungs- oder Netzmittel enthalten können, entfernen die vom Licht getroffenen Stellen der Kopierschicht und erzeugen so ein positives Abbild der Vorlage.

Bevorzugte Anwendung finden die erfindungsgemässen lichtempfindlichen Gemische bei der Herstellung von Druckformen, d.h. insbesondere Offset-, autotypischen Tiefdruck- und Siebdruckformen, in Kopierlacken und sogenannten Trokkenresists.

Die unter Verwendung der neuen Verbindungen hergestellten Druckplatten besitzen eine hohe praktische Lichtempfindlichkeit, sowie eine verbesserte Resistenz gegenüber alkalischen Entwicklern. Die bevorzugten Verbindungen selbst zeichnen sich durch eine hervorragende Löslichkeit in den üblichen Lösungsmitteln, durch eine gute Oleophilie sowie durch eine gute Verträglichkeit mit den übrigen Bestandteilen der Kopierschicht aus.

Die bemerkenswert gute Löslichkeit der erfindungsgemässen Naphthochinondiazid-sulfonsäureester, die wie oben beschrieben einen langkettigen aliphatischen Substituenten im Molekül haben, in den bevorzugten Beschichtungslösungsmitteln wird deutlich, wenn man bei gleicher kristalliner Beschaffenheit die Löslichkeit mit den entsprechenden bekannten Chinondiaziden vergleicht, die mit einem relativ kleinen aliphatischen Rest substituiert sind. Ein Vergleich der Löslichkeit in Ethylenglykolmonomethylether (EGMME) und in Butylacetat geht aus der folgenden Übersicht hervor:

| Verbindung der Formel I mit | Löslichkeit in Gew.% bei 23°C in | |
|---|---|---|
| | Butylacetat | EGMME |
| n = 2 | 0,166 | 0,830 |
| $R_2$=Hn = 15 | > 50,00 | > 50,00 |
| n = 17 | > 50,00 | > 50,00 |
| n = 1 | 1,50 | 3,40 |
| $R_1$=Hn = 4 | 1,50 | 5,60 |
| n = 18 | 8,53 | > 50,00 |

Ein weiterer Vorteil der neuen lichtempfindlichen Trisnaphthochinondiazid-sulfonsäureester liegt darin, dass durch den langkettigen aliphatischen Substituenten die Schlagempfindlichkeit und die Explosionsgefährlichkeit wesentlich herabgesetzt werden, so dass diese Verbindungen in eine weniger bedenkliche Gefahrenklasse eingestuft werden können. Trisester mit ähnlicher Stellung der Chinondiazidgruppen im Molekül, aber mit einem räumlich relativ kleinen Substituenten, z.B. der Ester aus 1 Mol 2,3,4-Trihydroxy-benzophenon und 3 Mol Naphthochinon-(1,2)-diazid-(2)-5-sulfonsäure, sind nach der im deutschen Sprengstoffgesetz gegebenen Definition explosionsgefährlich und unterliegen somit auch einer für den Transport sehr ungünstigen Gefahrenklasse.

Die Erfindung wird an Hand der folgenden Beispiele näher erläutert, in denen Gewichtsteile (Gt) und Volumteile (Vt) im Verhältnis von g zu ccm stehen. Prozente sind, wenn nichts anderes angegeben ist, Gewichtsprozente.

Beispiel 1

Es wurden

1,27 Gt des Veresterungsproduktes aus 1 Mol 4-Octadecanoyl-pyrogallol und 3 Mol Naphthochinon-(1,2)-diazid-(2)-5-sulfonsäurechlorid (Zers. 120–125°C),
0,10 Gt Naphthochinon-(1,2)-diazid-(2)-4-sulfonsäurechlorid,
5,60 Gt eines Kresol-Formaldehyd-Novolaks mit einem Erweichungspunkt von 105–120°C,
0,43 Gt 2,3,4-Trihydroxy-benzophenon und
0,06 Gt Kristallviolett

in einem Lösungsmittelgemisch aus

30 Gt Ethylenglykolmonomethylether,
40 Gt Tetrahydrofuran und
10 Gt Butylacetat

gelöst. Mit dieser Lösung wurde eine elektrolytisch aufgerauhte und anodisierte Aluminiumplatte mit einem Oxidgewicht von 3,0 g/m² geschichtet. Der anodisierte Aluminiumträger war vor dem Aufbringen der lichtempfindlichen Kopierschicht mit einer wässrigen Lösung von Polyvinylphosphonsäure behandelt worden, wie es in der DE-PS 1 621 478 beschrieben ist.

Das so hergestellte vorsensibilisierte Material mit einem Schichtgewicht der lichtempfindlichen Schicht von ca. 2,40 g/cm² wurde unter einer transparenten Positiv-Vorlage bildmässig belichtet und anschliessend mit der folgenden Lösung entwickelt:

5,4 Gt Natriummetasilikat × 9 Wasser,
3,4 Gt Trinatriumphosphat × 12 Wasser,
0,3 Gt Natriumdihydrogenphosphat (wasserfrei) in
91,0 Gt Wasser.

Durch die Entwicklung wurden die vom Licht getroffenen Anteile der Kopierschicht entfernt, und es blieben die unbelichteten Bildstellen auf dem Schichtträger zurück, die die Druckschablone bildeten. Von der so hergestellten Druckform wurden in einer Offsetdruckmaschine etwa 200 000 einwandfreie Drucke erhalten.

Wenn in der oben angegebenen Rezeptur der Naphthochinondiazid-sulfonsäureester des 4-Octadecanoyl-pyrogallols durch den entsprechenden Ester eines kurzkettigen Acyl-pyrogallols, zum Beispiel des 4-Propionyl-pyrogallols, ersetzt und wie angegeben, eine Druckform hergestellt wurde, so hatte diese eine wesentlich schlechtere Qualität.

Während die Druckschablone, die den langkettigen Acylrest in dem Naphthochinondiazid-sulfonsäureester enthielt, auch nach fünf Minuten Einwirkung des Entwicklers bei Raumtemperatur noch einwandfrei war, waren die Rasterpunkte der entsprechenden Druckschablone mit der den kurzkettigen Acylrest enthaltenden Verbindung bereits nach einer Minute Einwirkung des Entwicklers stark angegriffen. Nach fünf Minuten war dann die gesamte Druckschablone bis auf geringe Restmengen vom Aluminiumträger abgelöst.

Bemerkenswert ist ferner die geringere Oleophilie der Druckschablone und die relativ niedrige Druckauflage gegenüber der nach Beispiel 1 hergestellten Druckplatte.

Auf die wesentlich bessere Löslichkeit des Chinondiazids mit einem langkettigen Acylrest im Molekül gegenüber der gleichen Verbindung mit einem kurzkettigen Acylrest wurde bereits hingewiesen.

In den folgenden Beispielen 2 bis 5 werden weitere Beschichtungslösungen angegeben, die ähnliche Ergebnisse lieferten. Wenn nicht gesondert vermerkt, entsprechen Herstellung und Verarbeitung der damit erhaltenen Flachdruckplatten den in Beispiel 1 beschriebenen Bedingungen.

Beispiel 2

Es wurden

1,30 Gt des Veresterungsproduktes aus 1 Mol

3,4,5-Trihydroxy-benzoesäuredodecylester und 3 Mol Naphthochinon-(1,2)-diazid-(2)-5-sulfonsäurechlorid (Zers. 115–120°C),
5,60 Gt des in Beispiel 1 angegebenen Novolaks,
0,12 Gt 4-(p-Tolylmercapto)-2,5-diethoxy-benzol diazoniumhexafluorophosphat,
0,44 Gt 2,3,4-Trihydroxy-benzophenon und
0,065 Gt Kristallviolett

in einem Lösungsmittelgemisch aus

40 Gt Ethylenglykolmonomethylether und
50 Gt Tetrahydrofuran

gelöst. Mit dieser Lösung wurde eine elektrolytisch aufgerauhte und anodisierte Aluminiumplatte beschichtet, die zuvor mit einer wässrigen Lösung von Polyvinylphosphonsäure behandelt worden war.

Beispiel 3
Es wurden

1,26 Gt Des Veresterungsproduktes aus 1 Mol 4-Hexadecanoyl-pyrogallol und 3 Mol Naphthochinon-(1,2)-diazid-(2)-5-sulfonsäurechlorid (Zers. 120–125°C),
5,60 Gt des in Beispiel 1 angegebenen Novolaks,
0,10 Gt 2-(4-Methoxy-naphth-1-yl)-4,6-bis-trichlormethyl-s-triazin,
0,40 Gt 2,4-Dihydroxy-benzophenon und
0,06 Gt Kristallviolett

in einem Lösungsmittelgemisch aus

80 Gt Ethylenglykolmonomethylether und
20 Gt Butylacetat

gelöst. Mit dieser Lösung wurde eine elektrolytisch aufgerauhte und anodisierte Aluminiumplatte derart beschichtet, dass ein Schichtgewicht von 2,0 g/$m^2$ resultierte.

Beispiel 4
Es wurden

1,10 Gt des Veresterungsproduktes aus 1 Mol 3,4,5-Trihydroxy-benzoesäure-octadecylester und 3 Mol Naphthochinon-(1,2)-diazid-(2)-5-sulfonsäurechlorid (Zers. 105–112°C),
5,90 Gt des in Beispiel 1 angegebenen Novolaks,
0,10 Gt Naphthochinon-(1,2-diazid-(2)-4-sulfonsäurechlorid,
0,27 Gt 2,3,4-Trihydroxy-benzophenon und
0,06 Gt Kristallviolett

in einem Gemisch von

80 Gt Ethylenglykolmonomethylether und
20 Gt Butylacetat

gelöst. Mit dieser Lösung wurde eine elektrolytisch aufgerauhte und anodisierte Aluminiumplatte beschichtet, die vor dem Aufbringen der Kopierschicht mit einer wässrigen Lösung von Polyvinylphosphonsäure behandelt worden war.

Beispiel 5
Dieses Beispiel beschreibt eine Kopierschichtlösung, die als Positiv-Kopierlack für verschiedene Zwecke, insbesondere für das Herstellen von Ätzschablonen, verwendet werden kann, zum Beispiel beim Ätzen von Formteilen und Schildern und bei der Herstellung von kopierten Schaltungen, insbesondere für die Mikroelektronik. Die Lösung wies eine gute Haltbarkeit auf. Die Beschichtungsart und die Schichtdicke können in weiten Grenzen den jeweiligen Anforderungen angepasst werden. Nach der Belichtung hoben sich die belichteten von den unbelichteten Gebieten kontrastreich ab. Die belichteten Gebiete liessen sich mit einem alkalischen Entwickler (pH etwa 12,8) mühelos entfernen.

Beschichtungslösung:

1,5 Gt des Veresterungsproduktes aus 1 Mol 3,4,5-Trihydroxy-benzoesäuredodecylester und 3 Mol Naphthochinon-(1,2)-diazid-(2)-5-sulfonsäurechlorid (Zers. 115–120°C),
0,4 Gt 4-(p-Tolylmercapto)-2,5-diethoxy-benzol-diazonium-hexafluorophosphat,
0,1 Gt Kristallviolett (C.I. 42555),
10,0 Gt des in Beispiel 1 angegebenen Novolaks und
2,0 Gt Epoxyharz mit einem Epoxyäquivalentgewicht von 450–500 und einem Schmelzbereich von 64–74°C in
40 Vt Ethylenglykolmonomethylether,
50 Vt Tetrahydrofuran und
10 Vt Butylacetat.

Mit dieser Lösung wurde eine mit einer 35 µm starken Kupferfolie kaschierte Isolierstoffplatte beschichtet.

Beispiel 6
Es wurden

1,30 Gt des Veresterungsproduktes aus 1 Mol 3,4,5-Trihydroxy-benzoesäuredodecylester und 3 Mol Naphthochinon-(1,2)-diazid-(2)-4-sulfonsäurechlorid (Zers. 105–110°C),
5,80 Gt des in Beispiel 1 angegebenen Novolaks,
0,16 Gt Naphthochinon-(1,2)-diazid-(2)-4-sulfonsäurechlorid,
0,10 Gt 2,3,4-Trihydroxy-benzophenon und
0,065 Gt Kristallviolett

in einem Lösungsmittelgemisch aus

60 Gt Ethylenglykolmonomethylether und
30 Gt Butylacetat

gelöst. Mit dieser Lösung wurde eine elektrolytisch aufgerauhte und anodisierte Aluminiumplatte beschichtet, die mit einer wässrigen Lösung von Polyvinylphosphonsäure nachbehandelt worden war.

Beispiel 7

Es wurden

1,200 Gt des Veresterungsproduktes aus 1 Mol 3,4,5-Trihydroxy-benzoesäuretetradecylester und 3 Mol Naphthochinon-(1,2)-diazid-(2)-5-sulfonsäurechlorid (Zers. 105–110°C),
5,900 Gt des in Beispiel 1 angegebenen Novolaks,
0,160 Gt Naphthochinon-(1,2)-diazid-(2)-4-sulfonsäurechlorid und
0,065 Gt Kristallviolett

in einem Lösungsmittelgemisch aus

40 Gt Ethylenglykolmonomethylether und
50 Gt Butylacetat

gelöst. Mit dieser Lösung wurde eine elektrolytisch aufgerauhte und anodisierte Aluminiumplatte beschichtet.

**Patentansprüche**

1. Lichtempfindliches Gemisch, das einen Naphthochinon-(1,2)-diazid-(2)-4- oder -5-sulfonsäureester eines Gallussäurealkylesters oder eines Pyrogallylalkylketons und ein wasserunlösliches, in wässrig-alkalischen Lösungen lösliches oder mindestens quellbares harzartiges Bindemittel enthält, dadurch gekennzeichnet, dass es einen Naphthochinondiazidsulfonsäureester der allgemeinen Formel I

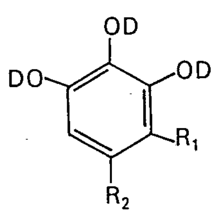

I

enthält, worin

D einen Naphthochinon-(1,2)-diazid-(2)-4-sulfonyl- oder einen Naphthochinon-(1,2)-diazid-(2)-5-sulfonylrest,
$R_1$ ein Wasserstoffatom oder den Rest $-COC_nH_{2n+1}$ und
$R_2$ ein Wasserstoffatom oder den Rest $-CO-OC_nH_{2n+1}$ bedeutet,

wobei

n eine Zahl von 10 bis 25 und die Summe der Kohlenstoffatome von $R_1 + R_2 = n + 1$ ist.

2. Lichtempfindliches Gemisch nach Anspruch 1, dadurch gekennzeichnet, dass es als alkalilösliches Bindemittel einen Phenolharz-Novolak enthält.

3. Lichtempfindliches Gemisch nach Anspruch 1, dadurch gekennzeichnet, dass es 3 bis 50 Gew.-%, bezogen auf seinen Gehalt an nichtflüchtigen Bestandteilen, an Verbindungen der Formel I enthält.

4. Lichtempfindliches Kopiermaterial aus einem Schichtträger und einer lichtempfindlichen Schicht, die einen Naphthochinon-(1,2)-diazid-(2)-4- oder -5-sulfonsäureester eines Gallussäurealkylesters oder eines Pyrogallylalkylketons und ein wasserunlösliches, in wässrig-alkalischen Lösungen lösliches oder mindestens quellbares harzartiges Bindemittel enthält, dadurch gekennzeichnet, dass der Naphthochinondiazidsulfonsäureester der allgemeinen Formel I

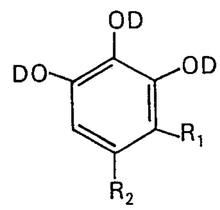

I

entspricht, worin

D einen Naphthochinon-(1,2)-diazid-(2)-4-sulfonyl- oder einen Naphthochinon-(1,2)-diazid-(2)-5-sulfonylrest,
$R_1$ ein Wasserstoffatom oder den Rest $-COC_nH_{2n+1}$ und
$R_2$ ein Wasserstoffatom oder den Rest $-CO-OC_nH_{2n+1}$ bedeutet,

wobei

n eine Zahl von 10 bis 25 und die Summe der Kohlenstoffatome von $R_1 + R_2 = n + 1$ ist.

5. Lichtempfindliches Kopiermaterial nach Anspruch 4, dadurch gekennzeichnet, dass der Schichtträger aus Aluminium besteht, dessen Oberfläche mechanisch oder elektrolytisch aufgerauht und anodisch oxydiert ist.

**Claims**

1. A light-sensitive mixture which contains a 1,2-naphthoquinone-2-diazide-4- or -5-sulfonic acid ester of a gallic acid alkyl ester or of a pyrogallyl alkyl ketone and a water-insoluble resinous binder, which is soluble or at least swellable in aqueous-alkaline solutions, wherein a naphthoquinone-diazide-sulfonic acid ester of the general formula I is contained

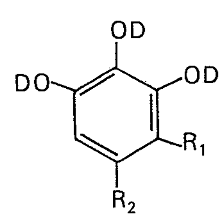

I

in which D is a 1,2-naphthoquinone-2-diazide-4-sulfonyl radical or a 1,2-naphthoquinone-2-diazide-5-sulfonyl radical; $R_1$ is a hydrogen atom or a $-COC_nH_{2n+1}$ radical; and $R_2$ is a hydrogen atom or a $-CO-OC_nH_{2n+1}$ radical, n being a number

from 10 to 25 and the sum of the carbon atoms of $R_1 + R_2$ being $n + 1$.

2. A light-sensitive mixture as claimed in claim 1, wherein a phenolic resin novolak is contained as the alkali-soluble binder.

3. A light-sensitive mixture as claimed in claim 1, wherein 3 to 50% by weight, relative to its content of non-volatile constituents, of compounds of the formula I are contained.

4. A light-sensitive copying material, composed of a layer support and a light-sensitive layer which contains a 1,2-naphthoquinone-2-diazide-4- or -5-sulfonic acid ester of a gallic acid alkyl ester or of a pyrogallyl alkyl ketone and a water-insoluble resinous binder, which is soluble or at least swellable in aqueous-alkaline solutions, wherein the naphthoquinone-diazide-sulfonic acid ester corresponds to the general formula I

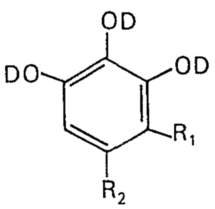

I

in which D is a 1,2-naphthoquinone-2-diazide-4-sulfonyl radical or a 1,2-naphthoquinone-2-diazide-5-sulfonyl radical; $R_1$ is a hydrogen atom or a $-COC_nH_{2n+1}$ radical; and $R_2$ is a hydrogen atom or a $-CO-OC_nH_{2n+1}$ radical, n being a number from 10 to 25 and the sum of the carbon atoms of $R_1 + R_2$ being $n + 1$.

5. A light-sensitive copying material as claimed in claim 4, wherein the support is composed of aluminum, the surface of which has been mechanically or eletrolytically roughened and anodically oxidized.

**Revendications**

1. Mélange photosensible, qui contient un ester de l'acide naphtoquinone-(1,2)-diazide-(2)-4- ou -5-sulfonique d'un ester alcoylique de l'acide gallique ou d'une pyrogallylalcoylcétone et un liant résineux insoluble dans l'eau et soluble ou au moins gonflable dans les solutions aqueuses alcalines, caractérisé en ce qu'il contient un ester de l'acide naphtoquinonediazidesulfonique répondant à la formule générale I

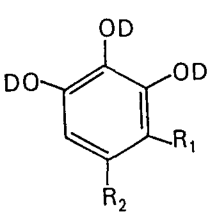

I

dans laquelle

D désigne un radical naphtoquinone-(1,2)-diazide-(2)-4-sulfonyle ou un radical naphtoquinone-(1,2)-diazide-(2)-5-sulfonyle,
$R_1$ désigne un atome d'hydrogène ou le radical $-COC_nH_{2n+1}$ et
$R_2$ désigne un atome d'hydrogène ou le radical $-CO-OC_nH_{2n+1}$, où
n est un nombre de 10 à 25 et la somme des atomes de carbone de $R_1 + R_2 = n + 1$.

2. Mélange photosensible suivant la revendication 1, caractérisé en ce qu'il contient comme liant soluble dans les alcalis une résine phénolique novolaque.

3. Mélange photosensible suivant la revendication 1, caractérisé en ce qu'il contient 3 à 50% en poids, par rapport à sa teneur en constituants non volatils, de composés répondant à la formule I.

4. Matériau de reproduction photosensible constitué d'un support et d'une couche photosensible, qui contient un ester de l'acide naphtoquinone-(1,2)-diazide-(2)-4- ou -5-sulfonique d'un ester alcoylique de l'acide gallique ou d'une pyrogallylalcoylcétone et un liant résineux insoluble dans l'eau, soluble ou au moins gonflable dans des solutions aqueuses alcalines, caractérisé en ce que l'ester de l'acide naphtoquinonediazidesulfonique répond à la formule générale I

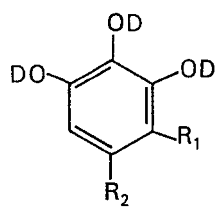

I

dans laquelle

D désigne un radical naphtoquinone-(1,2)-diazide-(2)-4-sulfonyle ou un radical naphtoquinone-(1,2)-diazide-(2)-5-sulfonyle,
$R_1$ désigne un atome d'hydrogène ou le radical $-COC_nH_{2n+1}$ et
$R_2$ désigne un atome d'hydrogène ou le radical $-CO-OC_nH_{2n+1}$, où
n est un nombre de 10 à 25 et la somme des atomes de carbone de $R_1 + R_2 = n + 1$.

5. Matériau de reproduction photosensible suivant la revendication 4, caractérisé en ce que le support se compose d'aluminium dont la surface a été dépolie mécaniquement ou électrolytiquement et oxydée anodiquement.